# EUROPÄISCHE PATENTSCHRIFT

(11) **EP 2 421 677 B1**
(45) Veröffentlichungstag und Bekanntmachung des Hinweises auf die Patenterteilung: **27.05.2020**
(21) Anmeldenummer: 10712715.1
(22) Anmeldetag: 31.03.2010
(51) Int. Cl.: B25B 11/00, H01L 21/683

(54) **AUFNAHMEEINRICHTUNG ZUR AUFNAHME VON HALBLEITERSUBSTRATEN**
RECEIVING DEVICE FOR RECEIVING SEMICONDUCTOR SUBSTRATES
DISPOSITIF DE LOGEMENT POUR LE LOGEMENT DE SUBSTRATS SEMI-CONDUCTEURS

(30) Priorität: 22.04.2009 DE 102009018434
(43) Veröffentlichungstag der Anmeldung: 29.02.2012
(73) Patentinhaber: EV Group GmbH, 4782 St. Florian am Inn (AT)
(72) Erfinder: TIEFENBÖCK, Herbert, A-4770 Andorf (AT); BURGGRAF, Jürgen, A-4780 Schärding/Inn (AT); PARGFRIEDER, Stefan, A-4204 Reichenau (AT); BURGSTALLER, Daniel, A-4910 Neuhofen/Innkreis (AT)
(74) Vertreter: Schneider, Sascha
(86) Internationale Anmeldenummer: PCT/EP2010/002052
(87) Internationale Veröffentlichungsnummer: WO 2010/121701

(56) Entgegenhaltungen:
- WO-A1-01/90820
- WO-A1-2004/011953
- WO-A1-2008/130173
- JP-A- 10 321 708
- JP-A- 2004 259 792
- JP-B2- 3 312 163
- US-A- 5 671 910
- US-A- 5 923 408
- US-A- 6 032 715

## Beschreibung

Die Erfindung betrifft eine Aufnahmeeinrichtung gemäß Anspruch 1.

Eine präzise und positionstreue Fixierung von Halbleitersubstraten ist für eine Vielzahl von Prozessen in der Halbleiterindustrie unumgänglich. Zur Handhabung solcher Halbleitersubstrate werden die meist sehr dünnen und anfälligen Halbleitersubstrate auf eine Aufnahmeeinrichtung, einen sogenannten Chuck, aufgebracht und dort fixiert. Die für die Fixierung von Halbleitersubstraten auf den Chucks bekannten Technologien sind insbesondere bei extrem dünnen Halbleitersubstraten mit einer Dicke von weniger als 100 µm, insbesondere weniger als 50 µm sowie bei Substraten mit einer Topographie nicht anwendbar.

Aufnahmeeinrichtungen sind in den Druckschriften US 5 671 910 A,

WO 2008/130173 A1, US 6 032 715 A, WO 2004/011953 A1 und der WO 01/90820 A1 offenbart. Die Druckschrift US 5 671 910 A offenbart ein Vakuumplattensystem mit einer Trägerplatte, die aus einer Vielzahl von Trägerplattenmodulen gebildet ist.

Eine sehr häufig verwendete Art der Fixierung erfolgt mit Hilfe von Vakuum beziehungsweise Unterdruck, wobei ein planes Halbleitersubstrat auf einer planen, gehärteten Oberfläche, in welche Vakuumbahnen gefräst sind, durch Unterdruck beziehungsweise Vakuum fixiert wird. Bei besonders dünnen Halbleitersubstraten können die Halbleitersubstrate entlang der Vakuumbahnen brechen oder zumindest beschädigt werden.

Ein noch größeres Problem stellt die Fixierung von Substraten mit sehr hoher Topographie dar, wobei die Topographie beispielsweise durch sogenannte Bumps erzeugt wird. Bumps sind kugel-, kegel- oder prismenförmig (quader) aufgetragene, leitende Materialien, die später zur elektrischen Kontaktierung von weiteren Bauteilen dienen. Die Bumps können eine Höhe von mehr als 500 µm, typischerweise zwischen 4-200 µm, meist zwischen 10-150 µm, aufweisen und in einer großen Vielzahl über die gesamte Substratfläche verteilt sein. Daraus folgt, dass eine Fixierung des Halbleitersubstrats mit den bekannten Verfahren nicht in ausreichendem Maße möglich ist.

Eine weitere Möglichkeit besteht in einer elektrostatischen Fixierung. Elektrostatische Fixiervorrichtungen haben jedoch den Nachteil, dass durch den Aufbau von elektrischen Feldern eine Beschädigung der komplexen Schaltungen auf den Halbleitersubstraten wahrscheinlich ist.

Es ist daher die Aufgabe der vorliegenden Erfindung, eine Aufnahmeeinrichtung zu schaffen, mit der dünne Halbleitersubstrate sowie Halbleitersubstrate mit einer Topographie sicher und auf schonende Art und Weise aufgenommen und fixiert werden können.

Diese Aufgabe wird mit den Merkmalen des Anspruchs 1 gelöst. Vorteilhafte Weiterbildungen der Erfindung sind in den Unteransprüchen angegeben.

Der Erfindung liegt der Gedanke zugrunde, eine gattungsgemäße Aufnahmeeinrichtung durch Vorsehen einer definierten Saugstruktur auf einer Aufnahmeseite der Aufnahmeeinrichtung bei gleichzeitiger Verwendung eines weichen Oberflächenmaterials beziehungsweise Materials der Saugstruktur zu verbessern. Durch Vorsehen eines nachgiebigen Materials an der das Halbleitersubstrat kontaktierenden Oberfläche kann eine schonende Aufnahme des Halbleitersubstrats, auch bei Vorhandensein von einer Topographie auf dem Halbleitersubstrat, gewährleistet werden. Indem das weiche Material gleichzeitig eine das Halbleitersubstrat ansaugende Saugstruktur aufweist, werden die aus dem Stand der Technik bekannten Nachteile vermieden und eine sichere und schonende Aufnahme von dünnen und/oder mit einer Topographie versehenen Halbleitersubstraten ist möglich.

Der Abstand zwischen benachbarten Erhebungen der Saugstruktur sollte dabei im Verhältnis zur Dicke des Halbleitersubstrats kleiner 1:7, insbesondere kleiner 1:5, bevorzugt kleiner 1:3, noch bevorzugter kleiner 1:2 sein. Analog gilt dies für Durchmesser etwaiger Topographien auf dem Halbleitersubstrat. Der Abstand zwischen benachbarten Erhebungen der Saugstruktur ist demnach maximal 7-fach im Vergleich zur Dicke des Halbleitersubstrats und/oder zum Durchmesser einzelner Topographien des auf der Aufnahmeeinrichtung aufzunehmenden Halbleitersubstrats.

In einer vorteilhaften Ausgestaltung der Erfindung ist vorgesehen, dass sich die Saugstruktur über die gesamte Aufnahmeseite erstreckt. Somit ist das gesamte Halbleitersubstrats auf schonende Art und Weise aufnehmbar.

Weiterhin ist mit Vorteil vorgesehen, dass die Saugstruktur eine Shorehärte von weniger als 90 Shore-A aufweist. Optimal für die einerseits stabile und andererseits schonende Halterung des Halbleitersubstrats ist ein weiches Material mit einer Shorehärte zwischen 10 Shore-A und 70 Shore-A, da auf das Halbleitersubstrat zum Teil hohe Auflage- und/oder Querkräfte wirken können. Außerdem ist es für eine hochgenaue Positionierung des Halbleitersubstrats erforderlich, dass das Halbleitersubstrat auf der Aufnahmeeinrichtung nicht schwimmt. Es hat sich jedoch überraschend herausgestellt, dass die Kombination aus weichem Material und Unterdruck auch für eine stabile Seitenführung beziehungsweise stabile Seitenfixierung Sorge trägt.

Indem der Aufnahmekörper aus dem weichen Material besteht, kann der Aufnahmekörper mit der Saugstruktur erfindungsgemäß als ein Teil gebildet sein.

Soweit die definierte Saugstruktur eine oder mehrere, insbesondere überwiegend in Umfangsrichtung des Aufnahmekörpers und/oder des Halbleitersubstrats verlaufende, Bahn(en) aufweist, lässt sich ein besonders definierter Unterdruck über die gesamte Fläche des Halbleitersubstrats aufbauen. Außerdem reicht durch die überwiegend in Umfangsrichtung des Aufnahmekörpers ausgerichteten Bahnen bereits ein geringfügiger Unterdruck aus, um das Halbleitersubstrat sicher zu fixieren.

In einer weiteren vorteilhaften Ausführungsform der Erfindung ist vorgesehen, dass die Saugstruktur, insbesondere im Querschnitt benachbarter Bahnen, zahnartig ausgebildet ist.

Mit Vorteil ist weiterhin vorgesehen, dass mindestens eine, insbesondere aus Erhebungen und Vertiefungen bestehende, Bahn spiralförmig, insbesondere von einem Zentrum Z des Aufnahmekörpers aus, verläuft. Eine spiralförmige Bahn lässt sich herstellungstechnisch einerseits leicht verwirklichen und andererseits wird ein maximaler Weg vom Zentrum der Aufnahmeeinrichtung bis zum Umfang der Aufnahmeeinrichtung verwirklicht, so dass ein optimaler Verlauf des an der Bahn anliegenden Unterdrucks gewährleistet ist.

Indem das weiche Material erfindungsgemäß elektrisch leitend ausgebildet ist, können etwaige elektrostatische Aufladungen vermieden werden, beispielsweise durch Erdung der Aufnahmeeinrichtung.

Gemäß einer weiteren vorteilhaften Ausführungsform der Erfindung ist vorgesehen, dass die Aufnahmeseite eine Aufnahmeebene A bildet und Seitenwände der Vertiefungen zur Aufnahmeebene A, insbesondere gleichwinkelig, angewinkelt sind, insbesondere in zwischen 30° und 85°, vorzugsweise zwischen 50° und 70°, liegenden Winkeln W1/W2. Der Winkel W1 gilt für eine erste Seitenwand der Vertiefung und der Winkel W2 für eine zweite Seitenwand der Vertiefung.

Dabei ist es von besonderem Vorteil, wenn die Saugstruktur Topographien des Halbleitersubstrats durch die Elastizität und Geometrie der Saugstruktur aufnehmend ausgebildet ist.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1:: eine mikroskopische Aufnahme einer auf einem Halbleitersubstrat 4 aufgebrachten Topographie 5 und
- Fig. 2:: eine schematische Darstellung der erfindungsgemäßen Aufnahmeeinrichtung und
- Fig. 3:: einen schematischen Ausschnitt aus der erfindungsgemäßen Saugstruktur aus weichem Material.

In den Figuren sind gleiche Bauteile und Bauteile mit der gleichen Funktion mit den gleichen Bezugszeichen gekennzeichnet.

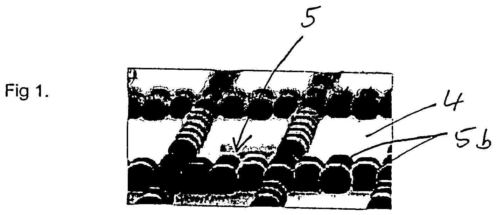

Figur 1 zeigt einen Ausschnitt eines Halbleitersubstrats 4 mit einer Topographie 5, nämlich einzelnen Bumps 5b, die auf der Oberfläche des Halbleitersubstrats 4 verteilt angeordnet sind.

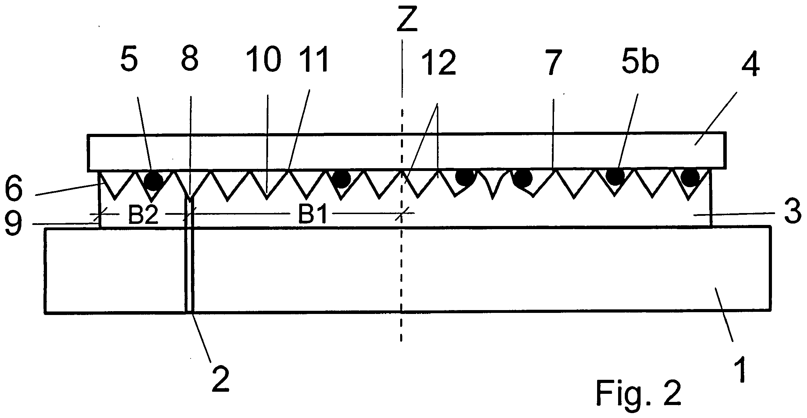

In Figur 2 ist eine Aufnahmeeinrichtung bestehend aus einem Träger 1 und einem auf dem Träger 1 fixierten Aufnahmekörper 3 dargestellt. Der Träger 1 kann beispielsweise zur Aufnahme durch einen Roboterarm oder eine Prozessstation dienen und ist daher vorzugsweise aus starrem Material, insbesondere Metall, gebildet. Der Träger 1 weist mit Vorteil eine größere Grundfläche als der Aufnahmekörper 3 auf. Der Aufnahmekörper 3 ist gegenüber dem Träger 1 aus einem weicheren Material gebildet. Das weiche Material kann beispielsweise Viton, Silikon, Gummi, NBR (Nitrilkautschuke), Neoprene etc. sein.

Auf einer vom Träger 1 abgewandten Aufnahmeseite 7 des Aufnahmekörpers 3 ist das Halbleitersubstrat 4 mit seiner Topographie 5 aufnehmbar. Das Halbleitersubstrat 4 kann auch mit der Topographie 5 nach oben gerichtet, also von der Aufnahmeseite 7 weg, aufgenommen werden.

Der Aufnahmekörper 3 ist von einem Unterdruckkanal 2 durchsetzt, der sich weiter durch den Träger 1 bis zu einer nicht dargestellten Vakuumeinrichtung zum Anlegen eines Vakuums an einem auf der Aufnahmeseite 7 angeordneten Saugende 8 erstreckt. Erfindungsgemäß können mehrere Unterdruckkanäle 2 verteilt über den Aufnahmekörper 3 angeordnet sein. Von Vorteil ist eine Anordnung des Unterdruckkanals 2 beziehungsweise des Saugendes 8 außerhalb eines Zentrums Z des Aufnahmekörpers 3. Besonders vorteilhaft ist es, wenn der Abstand B1 vom Zentrum Z zum Saugende 8 größer ist als der Abstand B2 vom Saugende 8 zu einem Umfang 9 des Aufnahmekörpers 3. Besonders vorteilhaft ist ein Verhältnis B1:B2 von 1,5:1 bis 3:1, vorzugsweise 2:1.

Das Saugende 8 ist in einer Vertiefung 10 der Saugstruktur 6 angeordnet und den Vertiefungen 10 sind die Saugstruktur 6 ausbildende Erhebungen 11 benachbart. Die Erhebungen 11 sind im vorliegenden Fall zahnartig, wobei die Vertiefungen 10 und Erhebungen 11 durch eine im Zentrum Z beginnende spiralförmige Bahn 12 gebildet sind. Die spiralförmige Bahn 12 bildet die definierte Saugstruktur 6 und durch die Spiralstruktur wird ein hoher Strömungswiderstand vom Zentrum Z zum Umfang 9 erreicht, der für ein stabiles Ansaugen des Halbleitersubstrats 4 an dem Aufnahmekörper 3 Sorge trägt.

In den Vertiefungen 10 der Bahn 12 sind die Bumps 5b aufnehmbar.

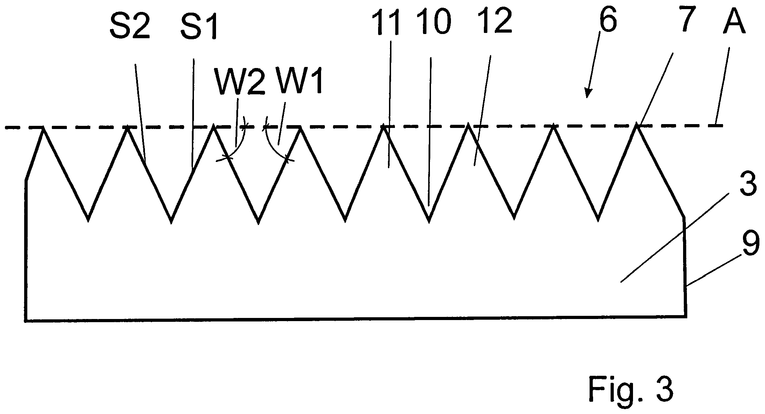

Figur 3 zeigt einen vergrößerten Ausschnitt des Aufnahmekörpers 3. Seitenwände S1, S2 der Vertiefungen 10 sind gegenüber einer durch die Aufnahmeseite 7 des Aufnahmekörpers 3 gebildeten Aufnahmeebene A angewinkelt, und zwar gleichwinklig mit den im Ausführungsbeispiel identischen Winkeln W1, W2 zwischen den Seitenwänden S1, S2 und der Aufnahmeebene A. Die Winkel W1, W2 liegen zwischen 30° und 85°, vorzugsweise zwischen 40° und 75°.

Die in Figur 3 spitz dargestellten Erhebungen 11 können in einer vorteilhaften Ausführungsform der Erfindung abgerundet sein.

Ein besonderer Vorteil der Erfindung liegt außerdem darin, dass mit ein und derselben Aufnahmeeinrichtung verschiedene Halbleitersubstrate, insbesondere auch im Durchmesser verschiedene Halbleitersubstrate 4 sicher und schonend aufgenommen werden können.

Besonders sicher und schonend werden Halbleitersubstrate 4 aufgenommen, die im Wesentlichen dieselbe Außenkontur und/oder denselben Außenumfang und/oder denselben Durchmesser wie der Aufnahmekörper 3 aufweisen.

### Bezugszeichenliste

- 1: Träger
- 2: Unterdruckkanal
- 3: Aufnahmekörper
- 4: Halbleitersubstrat
- 5: Topographie
- 5b: Bumps
- 6: Saugstruktur
- 7: Aufnahmeseite
- 8: Saugende
- 9: Umfang
- 10: Vertiefungen
- 11: Erhebungen
- 12: Bahn

- S1/S2: Seitenwände
- Z: Zentrum
- A: Aufnahmeebene
- W1: Winkel
- W2: Winkel
- B1: Abstand
- B2: Abstand

## Patentansprüche

1. Aufnahmeeinrichtung zur Aufnahme von flächigen Halbleitersubstraten (4) mit
- einem Träger (1),
- einem auf dem Träger (1) fixierten oder fixierbaren Aufnahmekörper (3) mit einer vom Träger (1) abgewandten Aufnahmeseite (7) und
- mindestens einem den Aufnahmekörper (3) durchsetzenden Unterdruckkanal (2) mit einem Saugende an der Aufnahmeseite (7), wobei die Aufnahmeseite (7) eine das Halbleitersubstrat (4) bei Anliegen von Unterdruck am Unterdruckkanal (2) ansaugende, definierte Saugstruktur (6) aus weichem Material aufweist,
wobei
der Aufnahmekörper (3) aus dem weichen Material besteht und mit der Saugstruktur als ein Teil ausgebildet ist, **dadurch gekennzeichnet, dass** das weiche Material elektrisch leitend ausgebildet ist, um elektrostatische Aufladungen zu vermeiden.

2. Aufnahmeeinrichtung nach Anspruch 1,
**dadurch gekennzeichnet,**
**dass** sich die Saugstruktur (6) über die gesamte Aufnahmeseite (7) erstreckt.

3. Aufnahmeeinrichtung nach einem der vorhergehenden Ansprüche,
**dadurch gekennzeichnet,**
**dass** die Saugstruktur (6) eine Shore-Härte von weniger als 90 Shore-A aufweist

4. Aufnahmeeinrichtung nach einem der vorhergehenden Ansprüche,
**dadurch gekennzeichnet,**
**dass** die definierte Saugstruktur (6) eine oder mehrere, insbesondere überwiegend in Umfangsrichtung des Aufnahmekörpers (3) und/oder des Halbleitersubstrates verlaufende, Bahn(en) (12) aufweist.

5. Aufnahmeeinrichtung nach einem der vorhergehenden Ansprüche,
**dadurch gekennzeichnet,**
**dass** die Saugstruktur (6), insbesondere im Querschnitt benachbarter Bahnen (12), zahnartig ausgebildet ist.

6. Aufnahmeeinrichtung nach einem der vorhergehenden Ansprüche,
**dadurch gekennzeichnet,**
**dass** mindestens eine aus Erhebungen (11) und Vertiefungen (10) bestehende Bahn (12) spiralförmig, insbesondere von einem Zentrum (Z) des Aufnahmekörpers (3) aus, verläuft.

7. Aufnahmeeinrichtung nach einem der vorhergehenden Ansprüche,
**dadurch gekennzeichnet,**
**dass** die Aufnahmeseite (7) eine Aufnahmeebene A bildet und Seitenwände (S1/S2) der Vertiefungen (10) zur Aufnahmeebene A, insbesondere gleichwinklig, angewinkelt sind, insbesondere in zwischen 30° und 85°, vorzugsweise zwischen 40° und 75°, liegenden Winkeln W1/W2.

8. Aufnahmeeinrichtung nach Anspruch 7,
**dadurch gekennzeichnet,**
**dass** die Saugstruktur (6) Topographien (5) des Halbleitersubstrats (4) aufnehmend ausgebildet ist.

## Claims

1. A workholding fixture for holding flat semiconductor substrates (4) with
- a carrier (1),
- a workholding body (3) which is fixed or which can be fixed on the carrier (1) with a workholding side (7) which faces away from the carrier (1) and
- at least one negative pressure channel (2) which penetrates the workholding body (3) with one suction end on the workholding side (7), the workholding side (7) having a defined suction structure (6) of soft material which applies suction to the semiconductor substrate (4) when negative pressure is applied to the negative pressure channel (2),
wherein
the workholding body (3) is made of a soft material and together with the suction structure is formed as a part, wherein the soft material is made electrically conductive in order to prevent electrostatic charging.

2. The workholding fixture as claimed in claim 1,
**characterized in that**
the suction structure (6) extends over the entire workholding side (7).

3. The workholding fixture as claimed in one of the preceding claims,
**characterized in that**
the suction structure (6) has a Shore hardness of less than 90 Shore-A.

4. The workholding fixture as claimed in one of the preceding claims,
**characterized in that**
the defined suction structure (6) has one or more path(s) (12) which run especially predominantly in the peripheral direction of the workholding body (3) and/or of the semiconductor substrate.

5. The workholding fixture as claimed in one of the preceding claims,
**characterized in that**
the suction structure (6) of paths (12) adjacent especially in cross section, is made tooth-like.

6. The workholding fixture as claimed in one of the preceding claims,
**characterized in that**
at least one path (12) consisting of elevations (11) and depressions (10) runs helically, especially out of the center (Z) of the workholding body (3).

7. The workholding fixture as claimed in one of the preceding claims,
**characterized in that**
the workholding side (7) forms a workholding plane A and side walls (S1/S2) of the depressions (10) are angled to the workholding plane A, especially at the same angle, especially in angles W1/W2 which are between 30° and 85°, preferably between 40° and 75°.

8. The workholding fixture as claimed in claim 7,
**characterized in that**
the suction structure (6) is made to accommodate topographies (5) of the semiconductor substrate (4).

## Revendications

1. Dispositif de réception pour recevoir des substrats de semiconducteurs (4) plats, comprenant
- un support (1),
- un corps de réception (3) fixé ou pouvant être fixé sur le support (1), comprenant une face de réception (7) détournée du support (1) et
- au moins un canal de dépression (2) traversant le corps de réception (3) avec une extrémité d'aspiration sur la face de réception (7), dans lequel la face de réception (7) présente une structure d'aspiration (6) en matériau souple aspirant le substrat de semi-conducteur (4) lors de l'application de dépression sur le canal de dépression (2),
dans lequel
le corps de réception (3) est réalisé dans le matériau souple et est constitué en tant qu'une partie avec la structure d'aspiration, **caractérisé en ce que** le matériau souple est conçu conducteur électrique pour éviter les charges électrostatiques.

2. Dispositif de réception selon la revendication 1,
**caractérisé en ce que**
la structure d'aspiration (6) s'étend sur toute la face de réception (7).

3. Dispositif de réception selon l'une des revendications précédentes,
**caractérisé en ce que**
la structure d'aspiration (6) présente une dureté Shore inférieure à 90 Shore A.

4. Dispositif de réception selon l'une des revendications précédentes,
**caractérisé en ce que**
la structure d'aspiration (6) définie présente une ou plusieurs voie(s) (12) passant principalement dans le sens périphérique du corps de réception (3) et/ou du substrat de semi-conducteur.

5. Dispositif de réception selon l'une des revendications précédentes,
**caractérisé en ce que**
la structure d'aspiration (6) est conçue en forme de dent, en particulier dans la section de voies (12) adjacentes.

6. Dispositif de réception selon l'une des revendications précédentes,
**caractérisé en ce qu'**
au moins une voie (12) constituée de rehaussements (11) et de renfoncements (10) est hélicoïdale, en particulier depuis un centre (Z) du corps de réception (3).

7. Dispositif de réception selon l'une des revendications précédentes,
**caractérisé en ce que**
la face de réception (7) forme un plan de réception A et des parois latérales (S1/S2) des renfoncements (10) sont angulaires par rapport au plan de réception A, en particulier en angle égal, en particulier dans des angles W1/W2 entre 30° et 85°, de préférence entre 40° et 75°.

8. Dispositif de réception selon la revendication 7,
**caractérisé en ce que**
la structure d'aspiration (6) est conçue pour recevoir des topographies (5) du substrat de semi-conducteur (4).
